# EUROPEAN PATENT SPECIFICATION

(11) **EP 3 610 275 B1**
(45) Date of publication and mention of the grant of the patent: **12.06.2024**
(21) Application number: 18809303.3
(22) Date of filing: 06.02.2018
(51) Int. Cl.: G01R 31/26, G01R 1/067, G01R 1/073, G01R 3/00, G01J 1/42, G01J 3/50

(54) **WAFER PROBE CARD, ANALYSIS APPARATUS INCLUDING THE SAME, AND METHOD OF FABRICATING THE WAFER PROBE CARD**
WAFER-SONDENKARTE, ANALYSEVORRICHTUNG DAMIT UND VERFAHREN ZUR HERSTELLUNG DER WAFER-SONDENKARTE
CARTE SONDE DE PLAQUETTE, APPAREIL D'ANALYSE COMPRENANT LADITE CARTE ET PROCÉDÉ DE FABRICATION DE LA CARTE SONDE DE PLAQUETTE

(30) Priority: 29.05.2017 US 201762512105 P; 16.08.2017 KR 20170103478
(43) Date of publication of application: 19.02.2020
(73) Proprietor: Samsung Electronics Co., Ltd., Suwon-si, Gyeonggi-do 16677 (KR)
(72) Inventor: JUNG, Jong Hoon, Suwon-si Gyeonggi-do 16547 (KR); KIM, Dae Sik, Suwon-si Gyeonggi-do 16513 (KR); KIM, Sung Yeol, Suwon-si Gyeonggi-do 16603 (KR); SHIN, Seung Yong, Bucheon-si Gyeonggi-do 14613 (KR)
(74) Representative: Appleyard Lees IP LLP
(86) International application number: PCT/KR2018/001595
(87) International publication number: WO 2018/221834

(56) References cited:
- EP-A1- 1 837 663
- EP-A1- 2 439 517
- WO-A1-2009/147718
- JP-A- 2012 198 194
- KR-A- 20100 057 258
- KR-A- 20100 071 750
- KR-A- 20120 037 352
- US-A1- 2013 001 405
- US-B1- 9 222 961
- US-B2- 7 948 252
- US-B2- 8 476 918

## Description

### [Technical Field]

Example embodiments of the present disclosure relate to a wafer probe card for evaluating micro light emitting diodes (LEDs), an analysis apparatus including the same, and a method of fabricating the wafer probe card.

### [Background Art]

Light-emitting devices such as light-emitting diodes (LED) or vertical cavity surface emitting laser diode (VCSELs) are inspected to evaluate electrical and optical characteristics thereof after completing the manufacture thereof.

According to conventional inspection methods, a small electrified probe may be brought into direct contact with an LED provided on a wafer to supply a current to the LED such that the LED emits light. An analysis system may acquire electrical and optical properties of light emitted from each LED provided on the wafer in the form of Blue Tape data.

Based on the data obtained as described above, manufacturers of high-brightness LED devices separate the LEDs from the wafer and supply the LEDs in accordance with wavelength and brightness required in a manufacturing process.

According to the conventional inspection methods, since LED devices including sapphire provided on a wafer may be larger in size, the LED devices may be sufficiently inspected by using the probe. However, in recent LED display apparatuses in which LEDs are used as display pixels, each LED is becoming smaller to several tens of micrometers (µm) in size.

When used to inspect LED devices having a size of several tens of micrometers (µm), the conventional inspection methods using a probe are not efficient since an inspection time increases due to inefficient supply of currents and frequent breakage of the probe.

EP1837663A1 discloses an inspection contact structure to contact with an object electrically to be inspected to inspect electric properties of the object to be inspected, and a probe card. US7948252B2 discloses a method of designing and manufacturing a probe card assembly. US9222961 B1 discloses a vertical probe card and a method for manufacturing the same. WO2009147718A1 discloses a method of manufacturing the probe wafer. US8476918B2 discloses a semiconductor test system.

### [Disclosure]

### [Technical Problem]

One or more example embodiments of the present disclosure provide a wafer probe card that matches in one-to-one correspondence with an LED wafer by implementing a probe system having the same size as the LED wafer and inspects brightness and wavelength of a plurality of LEDs at once by controlling the plurality of LEDs to emit light, an analysis apparatus including the same, and a method of fabricating the wafer probe card.

### [Technical Solution]

According to an aspect of an example embodiment, there is provided a probe card for a wafer including a substrate, an insulating layer formed on the substrate, a plurality of first pads and a plurality of second pads formed on the insulating layer, and a plurality of rear pads respectively connected to the plurality of first pads and the plurality of second pads via through silicon vias (TSVs), wherein the plurality of first pads and the plurality of second pads are configured to transfer electrical signals to electrode pads of a light emitting diode (LED) wafer.

The plurality of first pads are connected to each other in a line-by-line manner by an electric wiring in a first direction, the electric wiring connecting the first pads being connected to the TSVs connecting the first pads and rear pads, and the plurality of second pads are connected to each other in a line-by-line manner by an electric wiring in a second direction, the electric wiring connecting the second pads being connected to the TSVs connecting the second pads and rear pads.

The plurality of first pads are formed by etching the insulating layer provided with the plurality of first pads and re-depositing the plurality of first pads after depositing the plurality of second pads.

The substrate may be formed of silicon.

The wafer probe card may include holes for alignment with the LED wafer.

An anisotropic conductive film (ACF) and a polyimide (PI) film may be formed on the plurality of rear pads.

According to an aspect of another example embodiment, there is provided an analysis apparatus including an optical source application unit configured to transmit power to a wafer probe card;
an optical measurement unit configured to collect light emitted from a plurality of light emitting diodes (LEDs); and
a controller processor configured to execute instructions to control the optical source application unit and analyze the plurality of LEDs based on measurement results received from the optical measurement unit, wherein the wafer probe card comprises a substrate, an insulating layer formed on the substrate, a plurality of first pad pads and a plurality of second pads formed on the insulating layer, and a plurality of rear pads connected to each of the plurality of first pads and the second pads using through silicon vias (TSVs), wherein the plurality of first pads and the second pads are configured to transfer power from the optical source application unit to the plurality of LEDs.

The processor may be further configured to control the optical source application unit to alternately apply the power.

The processor may be further configured to create map data on the plurality of LEDs based on the measurement results, and the analysis apparatus may be further comprise a storage unit configured to store the created map data.

The processor may be further comprise a stage on which a wafer comprising the plurality of LEDs is placed, wherein the stage may be comprise a glass window configured to transmit emitted light, and the optical measurement unit may be further configured to collect light passing through the glass window.

According to an aspect of another example embodiment, there is provided a method of fabricating a probe card for a wafer, the method including preparing a substrate having an insulating layer formed to expose a plurality of first pads, forming a plurality of second pads on the insulating layer; and forming a plurality of rear pads formed on a surface opposite to a surface of the substrate provided with the insulating layer, wherein the plurality of rear pads are connected to the plurality of first pads and the plurality of second pads using through silicon vias (TSVs), wherein the plurality of first pads are connected to each other in a line-by-line manner by an electric wiring in a first direction, the electric wiring connecting the first pads being connected to the TSVs connecting the first pads and rear pads ,
the plurality of second pads are connected to each other in a line-by-line manner by an electric wiring in a second direction, the electric wiring connecting the second pads being connected to the TSVs connecting the second pads and rear pads, and
wherein the forming of the plurality of first pads comprises etching the insulating layer provided with the plurality of first pads and re-depositing the plurality of first pads after depositing the plurality of second pads.

The method may further include leveling the plurality of first pads and the plurality of second pads.

The method may further include forming an anisotropic conductive film (ACF) to the plurality of rear pads, and forming a polyimide (PI) film on the ACF.

### [Advantageous Effects]

According to the wafer probe card, the analysis apparatus including the same, and the method of fabricating the wafer probe card, the wafer probe card may match in one-to-one correspondence with the LED wafer by implementing a probe system having the same size as the LED wafer and inspect brightness and wavelength of a plurality of LEDs at once by controlling the plurality of LEDs to emit light.

### [Description of Drawings]

The above and/or other aspects of the disclosure will become apparent and more readily appreciated from the following description of the example embodiments, taken in conjunction with the accompanying drawings of which:
FIG. 1 is a schematic diagram illustrating an analysis apparatus including a wafer probe card according to an example embodiment;
FIG. 2 is a view for comparing a wafer probe card and an LED wafer according to an example embodiment;
FIGs. 3A and 3B are examples describing the operation of analysis apparatuses including different wafer probe cards according to example embodiments;
FIGs. 4A and 4B are top and bottom views of a wafer probe card according to an example embodiment;
FIG. 5 is a view for describing an operating method of a wafer probe card 100 according to an example embodiment;
FIG. 6 is a flowchart for describing a method of fabricating a wafer probe card according to an example embodiment; and
FIGs. 7 to 20 are diagrams for describing the method of fabricating the wafer probe card according to example embodiments.

### [Best Mode]

Reference will now be made in detail to the example embodiments of the present disclosure, examples of which are illustrated in the accompanying drawings, wherein like reference numerals refer to like elements throughout. This specification does not describe all elements of the embodiments of the present disclosure and detailed descriptions on what are well known in the art or redundant descriptions on substantially the same configurations may be omitted. As used herein, the terms "unit," "module," "member," and "block" may be implemented using a software or hardware component. According to an example embodiment, a plurality of "units," "modules," "members," and "blocks" may also be implemented using one element, and one "unit," "module," "member," and "block" may include a plurality of elements.

Throughout the specification, when an element is referred to as being "connected to" another element, it may be directly or indirectly connected to the other element and the "indirectly connected to" includes connected to the other element via a wireless communication network.

Also, it is to be understood that the terms "comprise," "include," and "have" indicate the existence of elements disclosed in the specification, but does not preclude the possibility that one or more other elements may exist or may be added.

Throughout the specification, it will be understood that when one element, is referred to as being "on" another element, it can be directly on the other element, or intervening elements may also be present therebetween.

It will be understood that, although the terms "first", "second", etc., may be used herein to describe various elements, these elements should not be limited by these terms. The above terms are used only to distinguish one component from another.

An expression used in the singular encompasses the expression of the plural, unless it has a clearly different meaning in the context.

The reference numerals used in operations are used for descriptive convenience and are not intended to describe the order of operations and the operations may be performed in a different order unless otherwise stated.

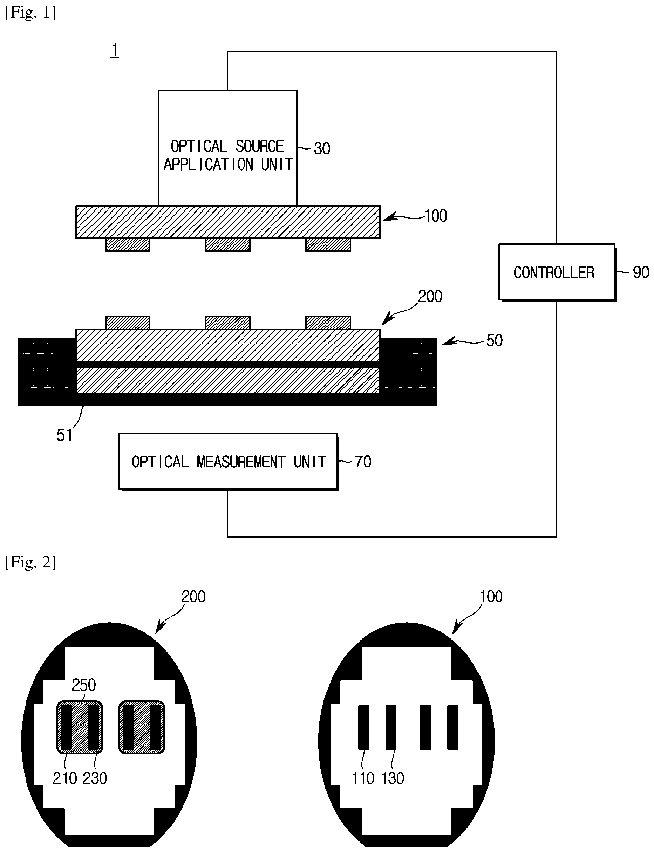

FIG. 1 is a schematic diagram illustrating an analysis apparatus including a wafer probe card according to an example embodiment.

Referring to FIG. 1, an analysis apparatus 1 may include a wafer probe card 100, an optical source application unit 30 configured to apply a current or voltage to the wafer probe card 100, a light-emitting diode (LED) wafer 200 configured to emit light upon receiving the current or voltage from the wafer probe card 100, a glass window 51 configured to transmit light emitted from LEDs included in the LED wafer 200, an optical measurement unit 70 configured to measure wavelength or brightness of light emitted from the LEDs included in the LED wafer 200, and a controller 90 configured to create map data based on signals received from the optical measurement unit 70 and control the overall operation of the analysis apparatus 1.

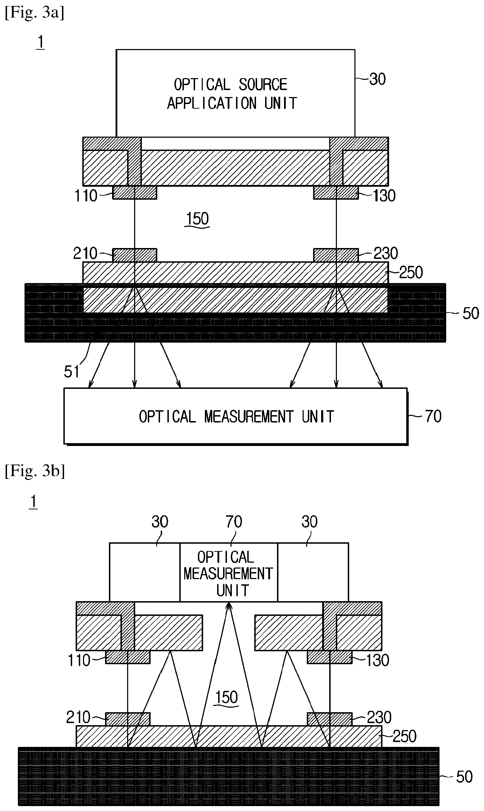

Particularly, the wafer probe card 100 may be provided in the same size as the LED wafer 200 to correspond to the LED wafer 200 and may transfer a current or voltage to the LED wafer 200 through pads 110 and 130 as illustrated in FIG. 3.

The LED wafer 200 is a target object to be analyzed by the analysis apparatus 1 and placed on a stage 50 of the analysis apparatus 1.

The LED wafer 200 includes LEDs of a predetermined size which includes electrode pads 210 and 230 as illustrated in FIG. 3 which may be brought into contact with the pads 110 and 130 of the wafer probe card 100, respectively.

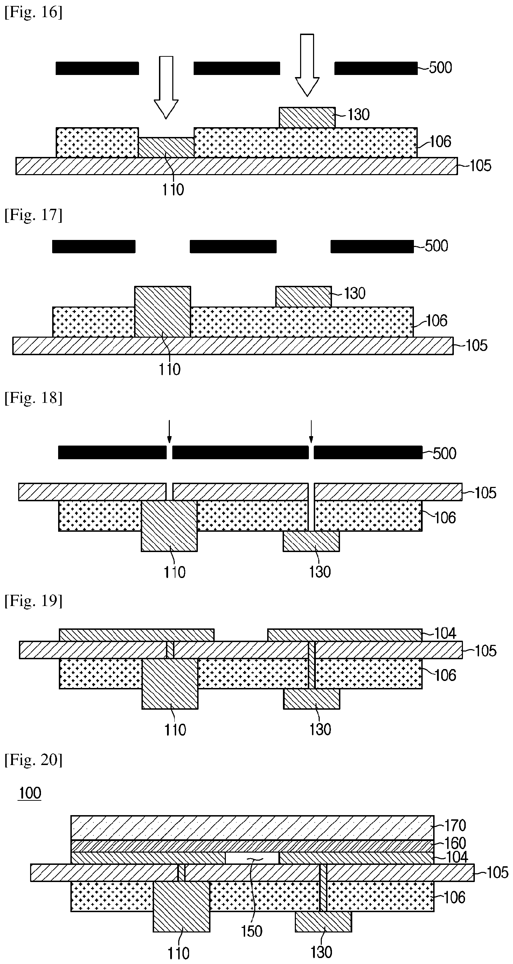

The optical source application unit 30 may transmit a voltage or current to the wafer probe card 100 in accordance with a control signal of the controller 90 and is connected specifically to a polyimide (PI) film 170 as illustrated in FIG. 20 included in the wafer probe card 100.

The optical measurement unit 70 may receive light emitted from the LEDs and transmit the measurement results to the controller 90. Specifically, the optical measurement unit 70 may measure an amount of the emitted light and collect a spectrum of light. The optical measurement unit 70 may convert the received light into an electrical signal by analyzing brightness or wavelength of the received light and may transmit the electrical signal to the controller 90.

The controller 90 may be a processor configured to control the overall operation of the analysis apparatus 1. Particularly, the controller 90 may control the optical source application unit 30, the optical measurement unit 70, and the stage 50, and output map data including evaluation results of the LEDs created by receiving the measurement results from the optical measurement unit 70.

The controller 90 may be implemented using a memory to store data on algorithms for controlling operations of the elements of the analysis apparatus 1 or programs for realizing the algorithms and a processor to perform the operations by using data stored in the memory. In this regard, the memory and the processor may be implemented using separate chips or integrated into a single chip.

The controller 90 may be connected to a storage unit configured to store the processed data. The storage unit may be implemented using at least one of a nonvolatile memory such as read only memory (ROM), programmable ROM (PROM), erasable programmable ROM (EPROM), electrically erasable programmable ROM (EEPROM), and flash memory, a volatile memory such as random access memory (RAM), or a storage medium such as hard disk drive (HDD) and CD-ROM, without being limited thereto. The storage unit may be a memory implemented as a separate chip from the processor described above with reference to the controller 90 or a memory integrated with the processor as a single chip.

The analysis apparatus 1 may further include one or more elements in addition to the elements illustrated in FIG. 1, or at least one of the elements illustrated in FIG. 1 may be excluded therefrom.

For example, the analysis apparatus 1 may further include an interface configured to output data processed by the controller 90 and receive an input command of a user, and a communication module configured to transmit the processed data to an external device.

The interface may be connected to a display configured to display the map data created by the controller 90. The display may be implemented using a cathode ray tube (CRT), a digital light processing (DLP) panel, a plasma display penal (PDP), a liquid crystal display (LCD) panel, an electro luminescence (EL) panel, an electrophoretic display (EPD) panel, an electrochromic display (ECD) panel, a light emitting diode (LED) panel, or an organic light emitting diode (OLED) panel, without being limited thereto.

In addition, the interface may be connected to a hardware device such as a button, a switch, a pedal, a keyboard, a mouse, a track-ball, a lever, a handle, and a stick which receive input commands of the user and a software device such as a graphic user interface (GUI), for example, a touch pad which connects a touch signal of the user together with the display.

FIG. 2 is a view comparing a wafer probe card 100 and an LED wafer 200 according to an example embodiment.

Referring to FIG. 2, the LED wafer 200 may include one or more LEDs 250. Two electrode pads 210 and 230 corresponding to P and N types are provided on each LED 250. Hereinafter, the P type electrode pad is referred to as a first LED electrode pad 210 and the N type electrode pad is referred to as a second LED electrode pad 230.

The wafer probe card 100 according to an example embodiment includes a first pad 110 and a second pad 130 to transfer a current or voltage respectively to the first LED electrode pad 210 and the second LED electrode pad 230 in direct contact therewith.

In addition, the wafer probe card 100 may include the first pads 110 and the second pads 130 in the same number and same size as the first and second LED electrode pads 210 and 230 of the LEDs 250 provided on the LED wafer 200 to be inspected.

Thus, all of the LEDs 250 may be simultaneously inspected by applying a current or voltage to the LEDs 250 by using the wafer probe card 100. Therefore, efficiency of the inspection may be increased according to an example embodiment.

FIGs. 3A and 3B are views for describing the operation of analysis apparatuses including different wafer probe cards according to example embodiments.

Referring to FIG. 3A, the optical source application unit 30 may transmit a current or voltage required for inspection of the first pad 110 and the second pad 130 of the wafer probe card 100 based on the control of the controller 90.

The wafer probe card 100 may transfer the voltage or current to the first LED electrode pad 210 and the second LED electrode pad 230 provided on the LED wafer 200 through the first pad 110 and the second pad 130, respectively.

The LED 250 may emit light upon receiving power from each of the first and second electrode pads 210 and 230.

Light emitted from the LED 250 may be transferred to the optical measurement unit 70 through the glass window 51 provided in the stage 50 and the optical measurement unit 70 collects the emitted light and analyzes brightness or wavelength of the light emitted from the LED 250.

According to an example embodiment, as illustrated in FIG. 3B, an optical measurement unit 70 included in an analysis apparatus 1 may be disposed in the same direction as the optical source application unit 30 with respect to the wafer probe card 100.

Light may be emitted from the LED 250 not in a particular direction, and thus, the light emitted from the LED 250 may be reflected by the stage 50.

Also, the wafer probe card 100 may include a silicon substrate on which the first pad 110 and the second pad 130 are mounted. Thus, light emitted from the LED 250 may be reflected by the first pad 110 and the second pad 130. However, example embodiments are not limited thereto. For example, a wafer probe card 100 according to an example embodiment as illustrated in FIG. 3B may include through silicon vias (TSVs) 150 and may transmit light emitted from the LED 250 at predetermined intervals.

Thus, the optical measurement unit 70 provided in the analysis apparatus 1 may collect light passing through the wafer probe card 100 of FIG. 3B and transfer the light to the controller 90.

FIGs. 3A and 3B schematically illustrate examples of the present disclosure, but example embodiments are not limited thereto.

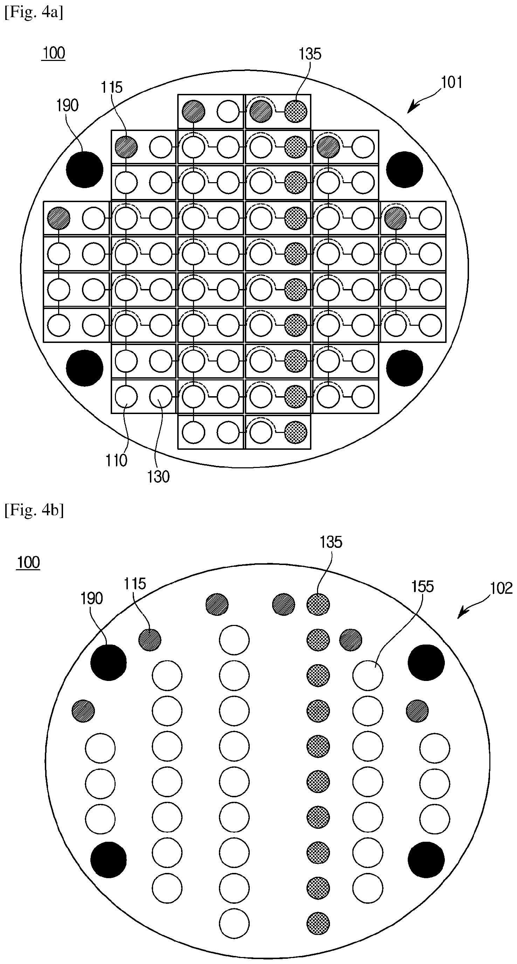

FIGs. 4A and 4B are top and bottom views of a wafer probe card 100 according to an example embodiment.

Specifically, FIG. 4A illustrates a bottom surface 101 of the wafer probe card 100 and FIG. 4B illustrates a top surface 102 of the wafer probe card 100.

As described above, the structure of the wafer probe card 100 may include the first pad 110 and the second pad 130 which are in one-to-one correspondence with the first LED electrode pad 210 and the second LED electrode pad 230 provided on the LED wafer 200 to be inspected. The first pad 110 and the second pad 130 may have the same size.

In addition, the wafer probe card 100 has align holes 190 for the purpose of alignment with the LEDs and the LED wafer 200. When the align holes 190 are formed in the bottom surface 101 and the top surface 102 of the wafer probe card 100, the align holes 190 are penetrated through the wafer probe card 100. The user may prevent the LED wafer 200 in contact with the wafer probe card 100 from being dislocated by using the align holes 190.

In the wafer probe card 100 illustrated in FIG. 4A, one first pad 110 is connected with another first pad 110 in a longitudinal direction (first direction) in a line-by-line manner via an electric wire. Also, one second pad 130 is connected to another second pad 130 in a lateral direction (second direction) via an electric wire.

In addition, in the wafer probe card 100, the electric wiring connecting the first pads 110 and the electric wiring connecting the second pads 130 are connected to TSV points 115 and 135 which are finally connected to an upper surface of the wafer probe card 100. The TSV points 115 and 135 are the through silicon vias (TSVs).

The TSV points 115 and 135 are pathways through which the first pad 110 and the second pad 130 are connected to the top surface and the bottom surface.

The TSV points 115 and 135 correspond to positive and negative poles of the power delivered by the optical source application unit 30. That is, the wafer probe card 100 may apply the current or voltage selectively to the first pads 110 and the second pads 130 of the wafer probe card 100 by controlling only the TSV points 115 and 135, and without connecting each of the first pads 110 and the second pads 130 with the positive and negative poles of the optical source application unit 30 in a one-to-one correspondence manner with each other.

For example, in order to apply a current or voltage to a first pad 110 and a second pad 130 indicated by reference numerals 110 and 130 illustrated in FIG. 4A, the current or voltage may be applied to a first TSV point 115 indicated by the reference numeral 115 in FIG. 4A and a second TSV point 135 in a second row from the last row and a column indicated by the reference numeral 135 of FIG. 4A

According to this example configuration, materials and structures required for conventional analysis apparatuses such as a substrate, a mold, and gold may be omitted. Since the first and second pads 110 and 130 may allow all LEDs 250 provided on the LED wafer 200 to emit light simultaneously, it is possible to omit separation/realignment processes performed by the conventional analysis apparatuses and it is possible to shorten an analysis time since a device for moving the analysis apparatus 1 such as a chuck is not required.

In the top surface 102 of the wafer probe card 100 shown in FIG. 4B, holes 155 are formed as TSVs between the first pads 110 and the second pads 130. The holes 155 may be filled with a conductive metal on the top surface 102 of the wafer probe card 100.

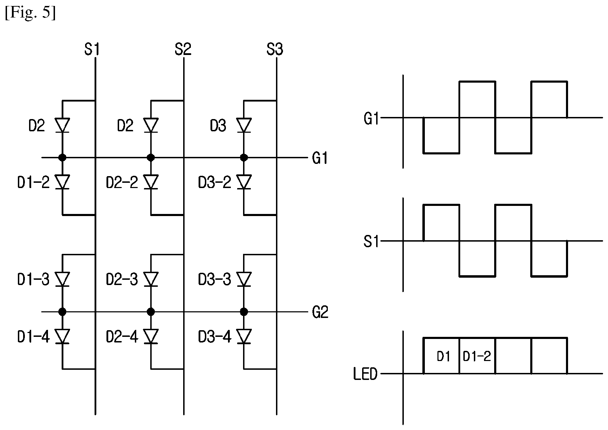

FIG. 5 is a view for describing an operating method of a wafer probe card 100 according to an example embodiment.

A wafer probe card 100 according to an example embodiment may alternately apply negative power and positive power to the first TSV point 115 and the second TSV point 135 in a manner different from the example embodiment described above with reference to FIGs. 4A and 4B.

When this structure is shown in a circuit diagram, diodes illustrated in FIG. 5 correspond to the first pads 110 and the second pads 130 respectively. In order to control an LED in contact with the first and second pads 110 and 130 corresponding to a diode D1 to emit light, a negative power is applied to a first gate G1 and a positive power is applied to a first source S1. In order to control an LED corresponding to a diode D1-2 to emit light, a positive power is applied to the first gate G1 and a negative power is applied to the first source S1.

That is, when the wafer probe card 100 is fabricated as illustrated the circuit diagram of FIG. 5, two LEDs may emit light by using one wiring by alternately applying positive and negative powers by the optical source application unit 30.

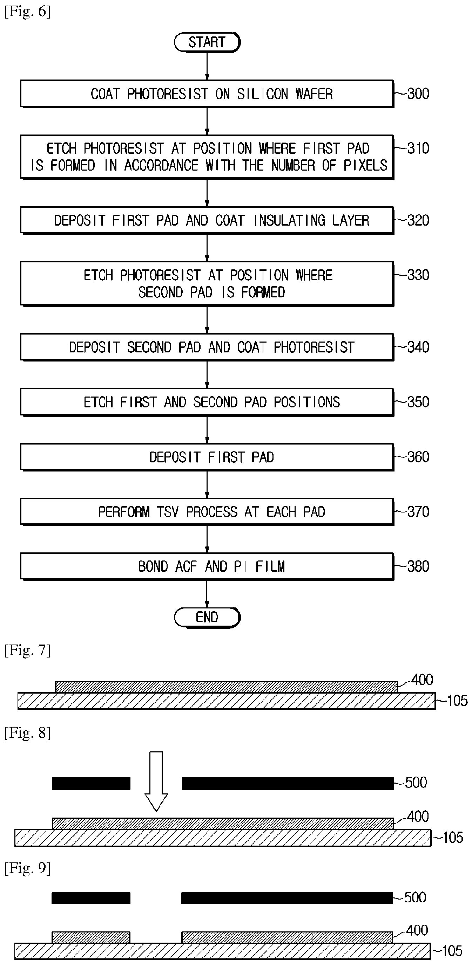

FIG. 6 is a flowchart for describing a method of fabricating a wafer probe card according to an example embodiment. In addition, FIGs. 7 to 20 are diagrams for describing the method of fabricating the wafer probe card.

A method of fabricating the wafer probe card 100 includes coating a photoresist 400 on a silicon wafer 105 as illustrated in FIG. 7 (300).

Next, the photoresist 400 is etched to correspond to a position of the first pad 110 in accordance with the number of pixels (310).

Specifically, a mask 500 corresponding to the position of the first pad 110 is used to form the first pad 110.

According to the example method, the photoresist 400 is exposed to light by using an exposure unit as illustrated in FIG. 8 and etched as illustrated in FIG. 9.

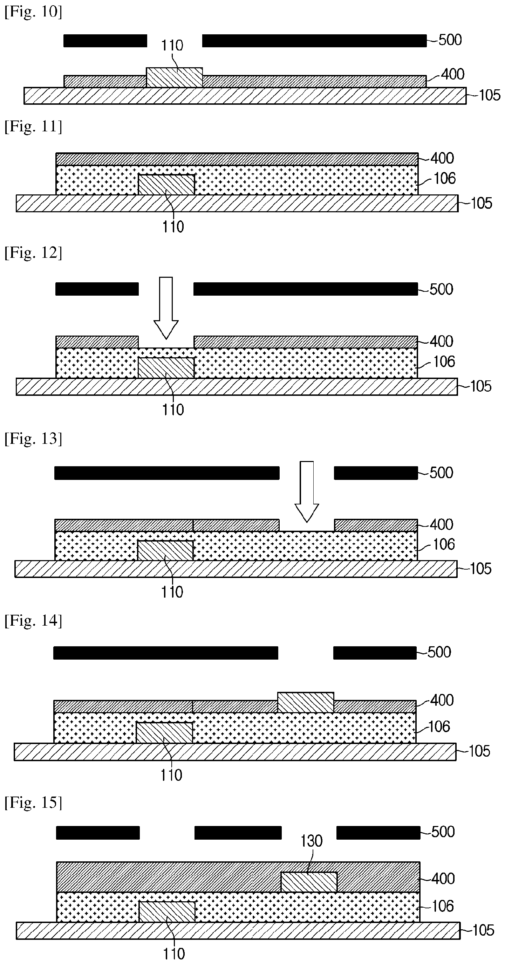

After etching, the first pad 110 is deposited thereon and an insulating material is coated thereon to form an insulating layer 106 as illustrated in FIG. 11 (320).

Specifically, the first pad 110 is formed on an etched region by deposition as illustrated in FIG. 10. Then, the insulating layer 106 is formed over the entire surface and the photoresist 400 is coated on the insulating layer 106 as illustrated in FIG. 11 to form a second pad 130. The insulating layer may be formed of silicon dioxide (SiO₂).

According to the example method, the photoresist 400 is etched at a position where the second pad 130 will be formed (330).

Specifically, according to the example fabrication method, the photoresist 400 and insulating layer 106 formed in the region of the first pad 110 is removed by light exposure before etching as illustrated in FIG. 12. Next, the photoresist 400 is etched at the position where the second pad 130 will be formed by using a mask 500 as illustrated in FIG. 13.

According to the fabrication method, the second pad 130 is deposited and the photoresist 400 is coated thereon again (340).

Specifically, the second pad 130 is deposited as illustrated in FIG. 14. Next, the photoresist 400 is coated thereon as illustrated in FIG. 15 to match flatness of each pad.

According to the example fabrication method, the regions corresponding to the first pad 110 and the second pad 130 are etched as illustrated in FIG. 16 (350).

Next, the first pad 110 is re-deposited on the position of the first pad 110 as illustrated in FIG. 17 (360).

According to the fabrication method, a TSV process for connection of rear surface wiring is performed by using the mask 500 as illustrated in FIG. 18 (370).

In the wafer probe card 100, a rear pad 104 is formed on the top surface of the silicon substrate 105 as illustrated in FIG. 19 via the TSV process.

The wafer probe card 100 is bonded to an anisotropic conductive film (ACF) 160 and a polyimide (PI) film 170 as illustrated in FIG. 20 (380).

Here, the ACF 160 is an anisotropic conductive film conducting electricity only in one direction and formed by mixing fine conductive particles with an adhesive resin, such as thermosetting resin, in a film state. The fine conductive particles included in the ACF 160 may be gold or silver.

In addition, the PI film 170 that withstands a high temperature of 400°C or higher and a low temperature of -269°C or lower is connected to the optical source application unit 30.

Meanwhile, the TSV 150 is formed between the rear pads 104 and the ACF 160 and the TSV 150 is connected to each of the first and second pads 110 and 130 such that electric wires are connected to form electrodes of the wafer probe card 100 as illustrated in FIGs. 4A and 4B.

When the wafer probe card 100 is fabricated as described above, a conventional process of using a probe may be omitted, an inspection time may be reduced by matching the wafer probe card 100 and the LED wafer in a one-to-one correspondence manner, and process complexity may be reduced by simplifying wiring required for light emission of the LEDs.

The above-described fabrication method is merely an example of fabricating the wafer probe card 100 and various modified methods may also be used therefor.

As is apparent from the above description, according to the wafer probe card, the analysis apparatus including the same, and the method of fabricating the wafer probe card, the wafer probe card may match in one-to-one correspondence with the LED wafer by implementing a probe system having the same size as the LED wafer and inspect brightness and wavelength of a plurality of LEDs at once by controlling the plurality of LEDs to emit light.

## Claims

1. A probe card (100) for a wafer (200) comprising:
a substrate (105);
an insulating layer (106) formed on the substrate (105);
a plurality of first pads (110) and a plurality of second pads (130) formed on the insulating layer (106); and
a plurality of rear pads (104) connected to the plurality of first pads (110) and the second pads (130), respectively, via through silicon vias, TSVs,
wherein the plurality of first pads (110) and the plurality of second pads (130) are configured to transfer electrical signals to electrode pads of a light emitting diode, LED, wafer (200),
wherein the plurality of first pads (110) are connected to each other in a line-by-line manner by an electric wiring in a first direction, the electric wiring connecting the first pads (110) being connected to the TSVs connecting the first pads (110) and rear pads (104), **characterised in that**
the plurality of second pads (130) are connected to each other in a line-by-line manner by an electric wiring in a second direction, the electric wiring connecting the second pads (130) being connected to the TSVs connecting the second pads (130) and rear pads (104), and
wherein the plurality of first pads (110) are formed by etching the insulating layer (106) provided with the plurality of first pads (110) and re-depositing the plurality of first pads (110) after depositing the plurality of second pads (130).

2. The probe card (100) of claim 1, wherein the substrate (105) is formed of silicon.

3. The probe card (100) of claim 1, wherein the probe card (100) comprises holes (190) for alignment with the LED wafer (200).

4. The probe card (100) of claim 1, wherein an anisotropic conductive film, ACF, (160) and a polyimide, PI, film (170) are formed on the plurality of rear pads (104).

5. An analysis apparatus (1) comprising:
a probe card (100) according to claim 1;
an optical source application unit (30) configured to transmit power to the probe card (100) of claim 1;
an optical measurement unit (70) configured to collect light emitted from a plurality of light emitting diodes, LEDs,
and transmit measurement results of the light collected; and
processor (90) configured to execute instructions to control the optical source application unit (30) and analyze the plurality of LEDs based on the measurement results received from the optical measurement unit (70).

6. The analysis apparatus (1) of claim 5, wherein the processor (90) is further configured to control the optical source application unit (30) to alternately apply the power.

7. The analysis apparatus (1) of claim 5, wherein in the probe card (100),
the processor (90) is configured to selectively apply power through the electric wiring in the first direction and the electric wiring in the second direction.

8. The analysis apparatus (1) of claim 5, wherein the processor (90) is further configured to create map data on the plurality of LEDs based on the measurement results, and
the analysis apparatus (1) further comprises a storage unit configured to store the created map data.

9. The analysis apparatus (1) of claim 5, further comprising a stage (50) on which a wafer (200) comprising the plurality of LEDs is placed,
wherein the stage (50) comprises a glass window (51) configured to transmit emitted light, and
the optical measurement unit (70) is further configured to collect light passing through the glass window (51).

10. A method of fabricating a probe card (100) for a wafer (200), the method comprising:
preparing a substrate (105) having an insulating layer (106) formed to expose a plurality of first pads (110);
forming a plurality of second pads (130) on the insulating layer (106); and
forming a plurality of rear pads (104) formed on a surface opposite to a surface of the substrate (105) provided with the insulating layer (106),
wherein the plurality of rear pads (104) are connected to the plurality of first pads (110) and the plurality of second pads (130) using through silicon vias, TSVs,
wherein the plurality of first pads (110) are connected to each other in a line-by-line manner by an electric wiring in a first direction, the electric wiring connecting the first pads (110) being connected to the TSVs connecting the first pads (110) and rear pads (104), **characterised in that**
the plurality of second pads (130) are connected to each other in a line-by-line manner by an electric wiring in a second direction, the electric wiring connecting the second pads (130) being connected to the TSVs connecting the second pads (130) and rear pads (104), and
wherein the forming of the plurality of first pads (110) comprises etching the insulating layer (106) provided with the plurality of first pads (110) and re-depositing the plurality of first pads (110) after depositing the plurality of second pads (130).

11. The method of claim 10, further comprising leveling the plurality of first pads (110) and the plurality of second pads (130).

12. The method of claim 10, further comprising bonding an anisotropic conductive film, ACF, (160) to the plurality of rear pads (104), and
forming a polyimide, PI, film (170) on the ACF (160).

## Patentansprüche

1. Nadelkarte (100) für eine Halbleiterscheibe (200), umfassend:
ein Substrat (105);
eine Isolierschicht (106), welche auf dem Substrat (105) gebildet ist;
eine Vielzahl von ersten (110) und eine Vielzahl von zweiten Kontaktflächen (130), welche auf der Isolierschicht (106) gebildet sind; und
eine Vielzahl von hinteren Kontaktflächen (104), welche mit der Vielzahl von ersten Kontaktflächen (110) bzw. der zweiten Kontaktflächen (130) mittels Silizium-Durchkontaktierungen, TSVs, verbunden sind,
wobei die Vielzahl von ersten Kontaktflächen (110) und die Vielzahl von zweiten Kontaktflächen (130) dazu konfiguriert sind, elektrische Signale an Elektrodenkontaktflächen einer Leuchtdioden-, LED-Halbleiterscheibe (200) zu übertragen,
wobei die Vielzahl von ersten Kontaktflächen (110) zeilenweise durch eine elektrische Verdrahtung in einer ersten Richtung miteinander verbunden sind, wobei die elektrische Verdrahtung die ersten Kontaktflächen (110) verbindet, welche mit den TSVs verbunden sind, welche die ersten Kontaktflächen (110) und hinteren Kontaktflächen (104) verbinden, **dadurch gekennzeichnet, dass**
die Vielzahl von zweiten Kontaktflächen (130) zeilenweise durch eine elektrische Verdrahtung in einer zweiten Richtung miteinander verbunden sind, wobei die elektrische Verdrahtung die zweiten Kontaktflächen (130) verbindet, welche mit den TSVs verbunden sind, welche die zweiten Kontaktflächen (130) und hinteren Kontaktflächen (104) verbindet, und
wobei die Vielzahl von ersten Kontaktflächen (110) durch Ätzen der Isolierschicht (106), welche mit der Vielzahl von ersten Kontaktflächen (110) versehen ist, und erneutes Aufbringen der Vielzahl von ersten Kontaktflächen (110) nach Aufbringen der Vielzahl von zweiten Kontaktflächen (130) gebildet werden.

2. Nadelkarte (100) nach Anspruch 1, wobei das Substrat (105) aus Silizium gebildet ist.

3. Nadelkarte (100) nach Anspruch 1, wobei die Nadelkarte (100) Löcher (190) zur Ausrichtung mit der LED-Halbleiterscheibe (200) umfasst.

4. Nadelkarte (100) nach Anspruch 1, wobei ein anisotropischer leitfähiger Film, ACF, (160) und ein Polyimid-, PI-Film (170) auf der Vielzahl von hinteren Kontaktflächen (104) gebildet werden.

5. Analyseeinrichtung (1) umfassend: eine Nadelkarte (100) nach Anspruch 1;
eine optische Quellenanwendungseinheit (30), welche dazu konfiguriert ist, Leistung an die Nadelkarte (100) nach Anspruch 1 zu übertragen;
eine optische Messeinheit (70), welche dazu konfiguriert ist, von einer Vielzahl von Leuchtdioden, LEDs, abgestrahltes Licht zu sammeln, und Messergebnisse des gesammelten Lichts zu übertragen; und
Prozessor (90), welcher dazu konfiguriert ist, Anweisungen auszuführen, um die optische Quellenanwendungseinheit (30) zu steuern und die Vielzahl von LEDs auf Basis der von der optischen Messeinheit (70) empfangenen Messergebnisse zu analysieren.

6. Analyseeinrichtung (1) nach Anspruch 5, wobei der Prozessor (90) weiter dazu konfiguriert ist, die optische Quellenanwendungseinheit (30) zu steuern, um die Leistung abwechselnd anzuwenden.

7. Analyseeinrichtung (1) nach Anspruch 5, wobei in der Nadelkarte (100) der Prozessor (90) dazu konfiguriert ist, selektiv Leistung durch die elektrische Verdrahtung in der ersten Richtung und die elektrische Verdrahtung in der zweiten Richtung anzuwenden.

8. Analyseeinrichtung (1) nach Anspruch 5, wobei der Prozessor (90) weiter dazu konfiguriert ist, Zuordnungsdaten für die Vielzahl von LEDs auf Basis der Messergebnisse zu erstellen, und
die Analyseeinrichtung (1) weiter eine Speichereinheit umfasst, welche dazu konfiguriert ist, die erstellten Zuordnungsdaten zu speichern.

9. Analyseeinrichtung (1) nach Anspruch 5, weiter eine Stufe (50) umfassend, auf welcher eine Halbleiterscheibe (200) platziert ist, welche die Vielzahl von LEDs umfasst,
wobei die Stufe (50) ein Glasfenster (51) umfasst, welches dazu konfiguriert ist, abgestrahltes Licht zu übertragen, und
die optische Messeinheit (70) weiter dazu konfiguriert ist, Licht zu sammeln, welches durch das Glasfenster (51) gelangt.

10. Verfahren zum Anfertigen einer Nadelkarte (100) für eine Halbleiterscheibe (200), wobei das Verfahren umfasst:
Herstellen eines Substrats (105) mit einer Isolierschicht (106), welche dazu ausgebildet ist, eine Vielzahl von ersten Kontaktflächen (110) zu exponieren; Bilden einer Vielzahl von zweiten Kontaktflächen (130) auf der Isolierschicht (106); und
Bilden einer Vielzahl von hinteren Kontaktflächen (104), welche auf einer Oberfläche gebildet sind, welche einer Oberfläche des Substrats (105), welche mit der Isolierschicht (106) versehen ist, gegenüberliegt,
wobei die Vielzahl von hinteren Kontaktflächen (104) mit der Vielzahl von ersten Kontaktflächen (110) bzw. der Vielzahl von zweiten Kontaktflächen (130) unter Verwendung von Silizium-Durchkontaktierungen, TSVs, verbunden sind,
wobei die Vielzahl von ersten Kontaktflächen (110) zeilenweise durch eine elektrische Verdrahtung in einer ersten Richtung miteinander verbunden sind, wobei die elektrische Verdrahtung die ersten Kontaktflächen (110) verbindet, welche mit den TSVs verbunden sind, welche die ersten Kontaktflächen (110) und hinteren Kontaktflächen (104) verbinden, **dadurch gekennzeichnet, dass**
die Vielzahl von zweiten Kontaktflächen (130) zeilenweise durch eine elektrische Verdrahtung in einer zweiten Richtung miteinander verbunden sind, wobei die elektrische Verdrahtung die zweiten Kontaktflächen (130) verbindet, welche mit den TSVs verbunden sind, welche die zweiten Kontaktflächen (130) und hinteren Kontaktflächen (104) verbindet, und
wobei das Bilden der Vielzahl von ersten Kontaktflächen (110) Ätzen der Isolierschicht (106), welche mit der Vielzahl von ersten Kontaktflächen (110) versehen ist, und erneutes Aufbringen der Vielzahl von ersten Kontaktflächen (110) nach Aufbringen der Vielzahl von zweiten Kontaktflächen (130) umfasst.

11. Verfahren nach Anspruch 10, weiter Nivellieren der Vielzahl von ersten Kontaktflächen (110) und der Vielzahl von zweiten Kontaktflächen (130) umfassend.

12. Verfahren nach Anspruch 10, weiter Binden eines anisotropen leitfähigen Films, ACF, (160) auf der Vielzahl von hinteren Kontaktflächen (104), und
Bilden eines Polyimid-, PI-Films (170) auf dem ACF (160) umfassend.

## Revendications

1. Carte de sonde (100) pour une plaquette (200) comprenant :
un substrat (105) ;
une couche isolante (106) formée sur le substrat(105) ; une pluralité de premiers tampons (110) et une pluralité de seconds tampons (130) formés sur la couche isolante (106) ; et
une pluralité de tampons arrière (104) connectés à la pluralité de premiers tampons (110) et aux seconds tampons (130), respectivement, à travers des vias traversants en silicium, TSV,
dans laquelle la pluralité de premiers tampons (110) et la pluralité de seconds tampons (130) sont configurés pour transférer des signaux électriques vers des tampons d'électrode d'une plaquette (200), d'une diode électroluminescente, LED,
dans laquelle la pluralité de premiers tampons (110) sont connectés les uns aux autres en ligne par ligne par un câblage électrique dans une première direction, le câblage électrique connectant les premiers tampons (110) étant connecté aux TSV connectant les premiers tampons (110) et des tampons arrière (104), **caractérisée en ce que** la pluralité de seconds tampons (130) sont connectés les uns aux autres en ligne par ligne par un câblage électrique dans une seconde direction, le câblage électrique connectant les seconds tampons (130) étant connecté aux TSV connectant les seconds tampons (130) et des tampons arrière (104), et
dans laquelle la pluralité de premiers tampons (110) sont formés par gravure de la couche isolante (106) dotée de la pluralité de premiers tampons (110) et la redéposition de la pluralité de premiers tampons (110) après avoir déposé la pluralité de seconds tampons (130).

2. Carte de sonde (100) selon la revendication 1, dans laquelle le substrat (105) est fait de silicium.

3. Carte de sonde (100) selon la revendication 1, dans laquelle la carte de sonde (100) comprend des trous (190) pour l'alignement avec la plaquette de LED (200).

4. Carte de sonde (100) selon la revendication 1, dans laquelle un film conducteur anisotrope, ACF, (160) et un film de polyimide, PI, (170) sont formés sur la pluralité de tampons arrière (104).

5. Appareil d'analyse (1) comprenant :
une carte de sonde (100) selon la revendication 1 ;
une unité d'application de source optique (30) configurée pour transmettre de l'énergie à la carte de sonde (100) selon la revendication 1 ;
une unité de mesure optique (70) configurée pour collecter la lumière émise par une pluralité de diodes électroluminescentes, LED, et transmettre des résultats de mesure de la lumière collectée ; et
un processeur (90) configuré pour exécuter des instructions pour commander l'unité d'application de source optique (30) et analyser la pluralité de LED sur la base des résultats de mesure reçus de l'unité de mesure optique (70).

6. Appareil d'analyse (1) selon la revendication 5,
dans lequel le processeur (90) est en outre configuré pour commander l'unité d'application de source optique (30) afin d'appliquer alternativement l'énergie.

7. Appareil d'analyse (1) selon la revendication 5, dans lequel dans la carte de sonde (100), le processeur (90) est configuré pour appliquer sélectivement de l'énergie à travers le câblage électrique dans la première direction et le câblage électrique dans la seconde direction.

8. Appareil d'analyse (1) selon la revendication 5, dans lequel le processeur (90) est en outre configuré pour créer des données cartographiques sur la pluralité de LED sur la base des résultats de mesure, et l'appareil d'analyse (1) comprend en outre une unité de stockage configurée pour stocker les données cartographiques créées.

9. Appareil d'analyse (1) selon la revendication 5, comprenant en outre un étage (50) sur lequel une plaquette (200) comprenant la pluralité de LED est placée, dans lequel l'étage (50) comprend une fenêtre en verre (51) configurée pour transmettre la lumière émise, et l'unité de mesure optique (70) est en outre configurée pour collecter la lumière traversant la fenêtre en verre (51) .

10. Procédé de fabrication d'une carte de sonde (100) pour une plaquette (200), le procédé comprenant :
la préparation d'un substrat (105) ayant une couche isolante (106) formée pour exposer une pluralité de premiers tampons (110) ;
la formation d'une pluralité de seconds tampons (130) sur la couche isolante (106) ; et
la formation d'une pluralité de tampons arrière (104) formés sur une surface opposée à une surface du substrat (105) dotée de la couche isolante (106),
dans lequel la pluralité de tampons arrière (104) sont connectés à la pluralité de premiers tampons (110) et à la pluralité de seconds tampons (130) à l'aide de vias traversants en silicium, TSV,
dans lequel la pluralité de premiers tampons (110) sont connectés les uns aux autres en ligne par ligne par un câblage électrique dans une première direction, le câblage électrique connectant les premiers tampons (110) étant connecté aux TSV connectant les premiers tampons (110) et des tampons arrière (104), **caractérisé en ce que** la pluralité de seconds tampons (130) sont connectés les uns aux autres en ligne par ligne par un câblage électrique dans une seconde direction, le câblage électrique connectant les seconds tampons (130) étant connecté aux TSV connectant les seconds tampons (130) et des tampons arrière (104), et
dans lequel la formation de la pluralité de premiers tampons (110) comprend la gravure de la couche isolante (106) dotée de la pluralité de premiers tampons (110) et la redéposition de la pluralité de premiers tampons (110) après avoir déposé la pluralité de seconds tampons (130).

11. Procédé selon la revendication 10, comprenant en outre le nivellement de la pluralité de premiers tampons (110) et de la pluralité de seconds tampons (130).

12. Procédé selon la revendication 10, comprenant en outre la liaison d'un film conducteur anisotrope, ACF, (160) à la pluralité de tampons arrière (104), et la formation d'un film polyimide, PI, (170) sur l'ACF (160).
